# FASCICULE DE BREVET EUROPEEN

(11) **EP 2 296 174 B1**
(45) Date de publication et mention de la délivrance du brevet: **06.06.2012**
(21) Numéro de dépôt: 10354041.5
(22) Date de dépôt: 31.08.2010
(51) Int. Cl.: H01L 21/336, H01L 21/60, H01L 21/768

(54) **Procédé de réalisation d'un dispositif à effet de champ ayant des connexions électriques autoalignées par rapport à l'électrode de grille**
Verfahren zur Herstellung einer Vorrichtung mit Feldeffekt, die über selbstausrichtende elektrische Verbindungen bezüglich der Gateelektrode verfügt
Method for manufacturing a device with field effect, with electrical connections self-aligned in relation to the gate electrode

(30) Priorité: 10.09.2009 FR 0904323
(43) Date de publication de la demande: 16.03.2011
(73) Titulaire: Commissariat à l'Énergie Atomique et aux Énergies Alternatives, 75015 Paris (FR)
(72) Inventeur: Fenouillet-Béranger, Claire, 38400 Saint Martin d'Hères (FR); Coronel, Philippe, 38530 Barraux (FR)
(74) Mandataire: Talbot, Alexandre

(56) Documents cités:
- US-A1- 2009 140 431
- US-B1- 6 303 449

## Description

### Domaine technique de l'invention

L'invention est relative à un procédé de réalisation d'un dispositif à effet de champ comportant, dans un premier niveau d'interconnexion métallique, des lignes de sorties de source, de drain et de grille connectées respectivement à des contacts de source, de drain et de grille, lesdits contacts étant disposés respectivement sur des électrodes de source, de drain et de grille.

### État de la technique

L'augmentation continue des performances des circuits intégrés, par exemple, en termes de consommation et/ou de fréquence de fonctionnement, se traduit inéluctablement par une diminution constante de la taille de ses composants. Afin de réaliser des dispositifs toujours plus performants, de nouvelles architectures et/ou de nouveaux matériaux ont été intégrés dans les transistors.

La diminution des dimensions du transistor se traduit par une augmentation des contraintes liées à l'alignement des différents niveaux photolithographiques les uns par rapport aux autres. De manière classique, dans la réalisation d'un transistor à effet de champ, la définition des zones de contact de source, de drain et de grille et l'alignement du premier niveau de métal par rapport à ces contacts font partie des étapes les plus critiques. En effet, les contacts doivent être alignés par rapport à l'électrode de grille qui est elle-même définie par rapport à la zone active au moyen d'un niveau photolithographique spécifique. Il en va de même de la connexion électrique réalisée par le premier niveau de métal qui réalise une partie de l'interconnexion de tous les transistors du circuit intégré. Il en résulte que les contacts et le premier niveau de métal doivent être alignés par rapport à la grille et leurs électrodes respectives tout en tenant compte du désalignement existant entre la zone active et la grille.

D'un point de vue industriel, l'alignement d'un niveau photolithographique par rapport à un autre se traduit par de fortes contraintes de répétabilité sur les équipements de photolithographie et par l'intégration des marges de sécurité dans le dessin des transistors. De ce fait, l'alignement des zones de contact est une étape critique dans le procédé de réalisation du transistor à effet de champ. Le désalignement aboutit à une très grande dispersion dans les performances des transistors obtenus et à des pertes de rendement des circuits fabriqués.

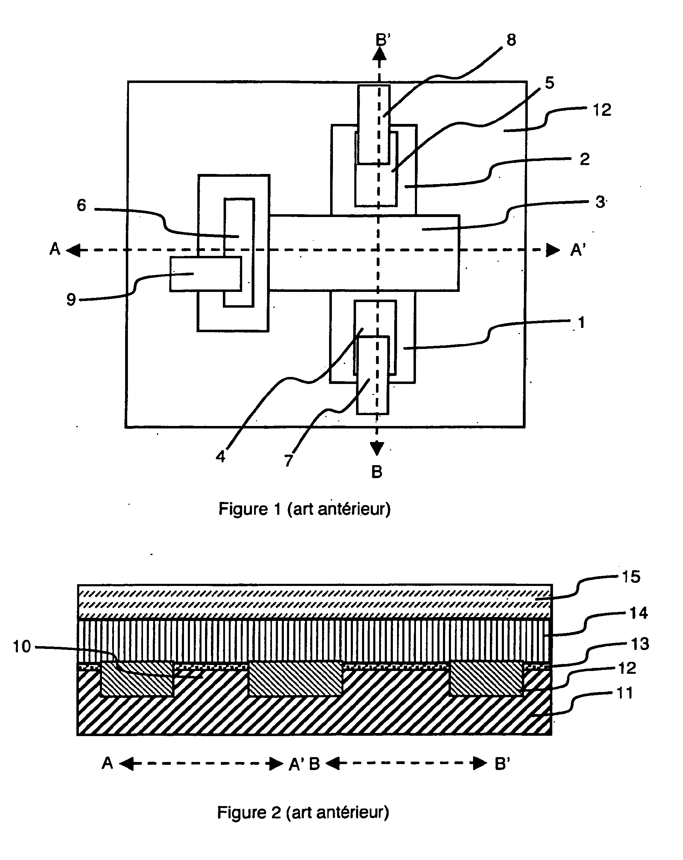

De manière conventionnelle, illustrée aux figures 1 à 6, un transistor à effet de champ comporte des électrodes de source 1, de drain 2 et de grille 3 qui comportent respectivement des zones de contact de source 4, de drain 5 et de grille 6. Les zones de contact de source 4, de drain 5 et de grille 6 sont recouvertes respectivement par les lignes de sortie de source 7, de drain 8 et de grille 9 du premier niveau de métal, également appelé Métal 1 ou M1.

Les électrodes de source 1 et de drain 2 sont formées dans une zone active de chaque côté d'un canal qui est disposé sous l'électrode de grille 3 (figure 1). Le canal et les électrodes de source 1 et de drain 2 sont formés dans la zone active, qui est une couche en matériau semi-conducteur 10.

Comme illustré à la figure 2, la zone active, en matériau semi-conducteur 10, est formée sur un substrat 11 et elle est entourée par un matériau diélectrique 12. Le matériau diélectrique 12 est, par exemple, un motif d'isolation latérale qui isole électriquement la zone active 10 des autres couches en matériau semi-conducteur qui sont présentes sur le substrat 11, c'est-à-dire des autres zones actives 10. La zone active 10 est typiquement en silicium, germanium, ou un alliage de ces matériaux, à l'état contraint ou relaxé. Le matériau diélectrique 12 est, par exemple, un matériau à base d'oxyde de silicium et le substrat 11 peut être un substrat massif en matériau semi-conducteur ou un substrat sur isolant de type SOI.

Comme illustré à la figure 2, un diélectrique de grille 13 et une couche en matériau de grille 14 sont ensuite formés sur le substrat 11. Le diélectrique de grille 13 peut être un oxyde de silicium ou un matériau à forte permittivité. Il est réalisé de manière classique, par exemple, par oxydation thermique, par dépôt chimique en phase vapeur assisté ou non, par plasma ou par dépôt de couches atomiques. Le matériau de grille 14 est classiquement un matériau semi-conducteur, par exemple en silicium polycristallin, mais il peut être également un matériau métallique. Typiquement, le matériau de grille 14 est déposé par dépôt chimique en phase vapeur.

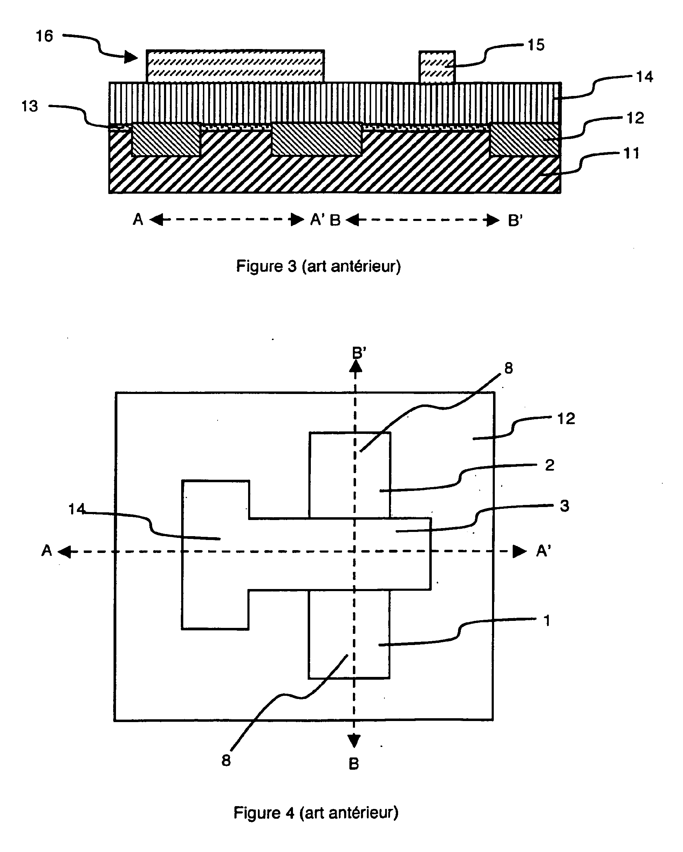

Un matériau de masquage 15 est ensuite déposé sur le matériau de grille 14 et il est structuré de manière à former un masque de gravure 16. Comme illustré à la figure 3, ce masque de gravure est alors utilisé comme masque dur pour structurer le matériau de grille 14 et former l'électrode de grille 3. Le masque de gravure 16 est formé de manière classique, c'est-à-dire au moyen d'une résine photosensible qui est insolée pour former un masque temporaire. Le masque temporaire est alors reporté par gravure dans la couche de masquage 15 pour former le masque de gravure 16 (figure 3).

Le masque de gravure 16 qui sert à dessiner l'électrode de grille 3 doit être aligné par rapport à la zone active 10. Il va définir indirectement les zones de source 1 et de drain 2 qui sont situées dans la zone active 10 de part et d'autre de la grille. De manière idéale, l'électrode de grille 3 est disposée au milieu de la zone active 10 de manière à avoir un dispositif symétrique, c'est-. à-dire des zones de source 1 et de drain 2 ayant sensiblement la même taille (figure 4).

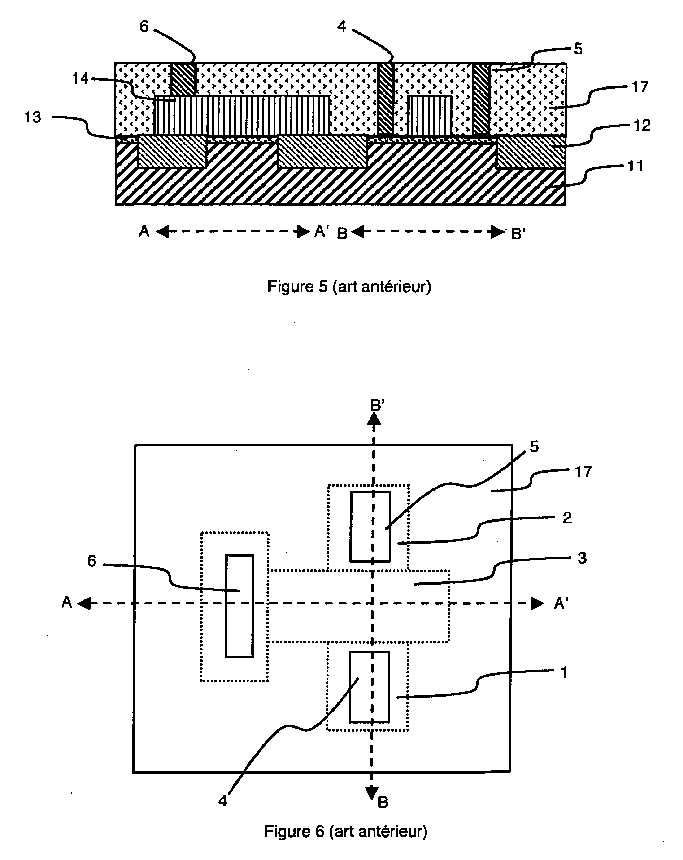

Comme illustré aux figures 5 et 6, les électrodes de source 1, de drain 2 et de grille 3 étant formées, un matériau de couverture 17 est déposé et un nouveau masque de gravure est formé. Ce nouveau masque de gravure est utilisé pour former des zones de contact de source 4, de drain 5 et de grille 6 respectivement sur les électrodes de source 1, de drain 2 et de grille 3 (en pointillé). Ce nouveau masque de gravure doit être aligné par rapport à la zone active 10 mais il doit également être aligné par rapport à l'électrode de grille 3. Sur la figure 6 vue de dessus, la zone active et l'électrode de grille sont toutes les deux recouvertes par le matériau de couverture 17.

Le désalignement des contacts de source et de drain par rapport à la grille fait qu'un contact de source ou de drain est plus proche du canal. Il en résulte alors une différence dans la valeur les capacités qui existe entre les contacts et la grille. Cette inégalité de valeur entraîne alors une dégradation des performances du transistor à cause de la modification de la résistance d'accès entre les électrodes de source et de drain. Il existe également un risque de court-circuit entre la grille et les contacts réalisés sur les zones de source et/ou de drain si le désalignement est trop important.

Une fois les contacts de source 4, de drain 5 et de grille 6 formés, ils sont recouverts par le premier niveau de métal, c'est-à-dire par des motifs en matériau métallique formés dans une couche en matériau isolant. Le premier niveau de métal constitue le premier des niveaux d'interconnexion du circuit intégré. C'est à partir de ce premier niveau de métal que les transistors commencent à être connectés les uns aux autres. Ce premier niveau de métal comporte des lignes de sortie de source 7, de drain 8 et de grille 9 qui sont connectées respectivement aux contacts de source 4, de drain 5 et de grille 6.

Les lignes de sortie de source 7, de drain 8 et de grille 9 du premier niveau de métal sont formées de manière analogue aux zones de contact de source 4, de drain 5 et de grille 6. Le matériau de couverture et les zones de contact sont recouverts par un nouveau matériau de couverture et ce dernier est structuré afin de permettre l'accès aux zones de contact et définir la forme des lignes de métal. Le premier niveau de métal (M1) connectant tous les transistors du circuit intégré, il est nécessaire de trouver un compromis entre les marges de sécurité des étapes photolithographiques et les dimensions des zones de connexion afin d'éviter les courts-circuits, assurer une compacité maximale et permettre l'obtention d'un circuit fonctionnelle malgré les variabilités du procédé de réalisation.

Là encore, le désalignement des lignes de sortie de source 7, de drain 8 et de grille 9 du premier niveau de métal par rapport aux contacts de source 4, de drain 5 et de grille 6 se traduit par une diminution des performances du dispositif et donc du circuit. La réalisation d'un dispositif utilisant les trois étapes photolithograhiques successives est illustrée dans le document US 2009/0140431.

### Objet de l'invention

L'invention a pour objet la réalisation d'un dispositif à effet de champ qui présente un alignement parfait des contacts de source et de drain par rapport à l'électrode de grille ainsi que des lignes de sortie de source, de drain et de grille du premier niveau d'interconnexion métallique par rapport aux contacts de source, de drain et de grille. De préférence, la zone de contact de grille est également parfaitement alignée par rapport à l'électrode de grille.

Le procédé selon l'invention est caractérisé en ce qu'il comporte successivement :
- la formation d'une couche d'isolation sur un diélectrique de grille,
- la réalisation d'un masque de gravure délimitant latéralement au moins l'électrode de grille, les contacts de source et de drain et les lignes de sortie de source, de drain et de grille du premier niveau d'interconnexion métallique,
- le masquage des lignes de sortie de source, de drain et de grille dans le masque de gravure,
- la délimitation simultanée de l'électrode de grille et des contacts de source et de drain dans le matériau d'isolation,
- le dépôt d'un matériau de grille formant au moins l'électrode de grille,
- la formation des contacts de source et de drain au moins dans la couche d'isolation, et des lignes de sortie de source, de drain et de grille du premier niveau de métal dans le masque de gravure.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 6 représentent, de manière schématique, en vue de dessus et en coupe des étapes successives de réalisation d'un procédé, selon l'art antérieur,
- les figures 7 à 19 représentent, de manière schématique, en vue de dessus et en coupe des étapes successives de réalisation d'un procédé, selon l'invention,
- les figures 20 et 21 représentent, de manière schématique, en vue de dessus et en coupe des étapes successives de réalisation d'une variante du procédé, selon l'invention,
- la figure 22 représente, de manière schématique, en vue de dessus une variante du procédé, selon l'invention
- les figures 23 à 27 représentent, de manière schématique, en vue de dessus et en coupe des étapes successives de réalisation d'une autre variante du procédé, selon l'invention.

### Description de modes de réalisation préférentiels de l'invention

Le procédé de réalisation du dispositif à effet de champ selon l'invention comporte successivement, sur le substrat 11, la formation du diélectrique de grille 13 et d'une couche d'isolation formée par une couche unique ou par un empilement de couches. La couche d'isolation comporte, par exemple, des première 18 et seconde 19 couches élémentaires en matériaux d'isolation. La couche d'isolation comporte également une couche supérieure d'isolation 20 à l'intérieure de laquelle est formé un masque de gravure 16, par exemple, par photolithographie et gravure. La couche d'isolation 18, 19, 20 est formée par un ou plusieurs matériaux diélectriques qui sont isolant électriquement, par exemple un oxyde et/ou un nitrure de silicium. La couche supérieure d'isolation 20 a typiquement une épaisseur de l'ordre de 250nm et la couche d'isolation a dans sa globalité une épaisseur de l'ordre de 700nm.

Le substrat 11 comporte également une zone active 10 en matériau semi-conducteur qui est entourée par un matériau diélectrique 12. Ainsi, la zone active est isolée électriquement, de manière latérale au moins, des autres zones actives par les motifs en matériau diélectrique 12. Le substrat 11 peut être un substrat massif en matériau semi-conducteur ou un substrat de type semi-conducteur sur isolant.

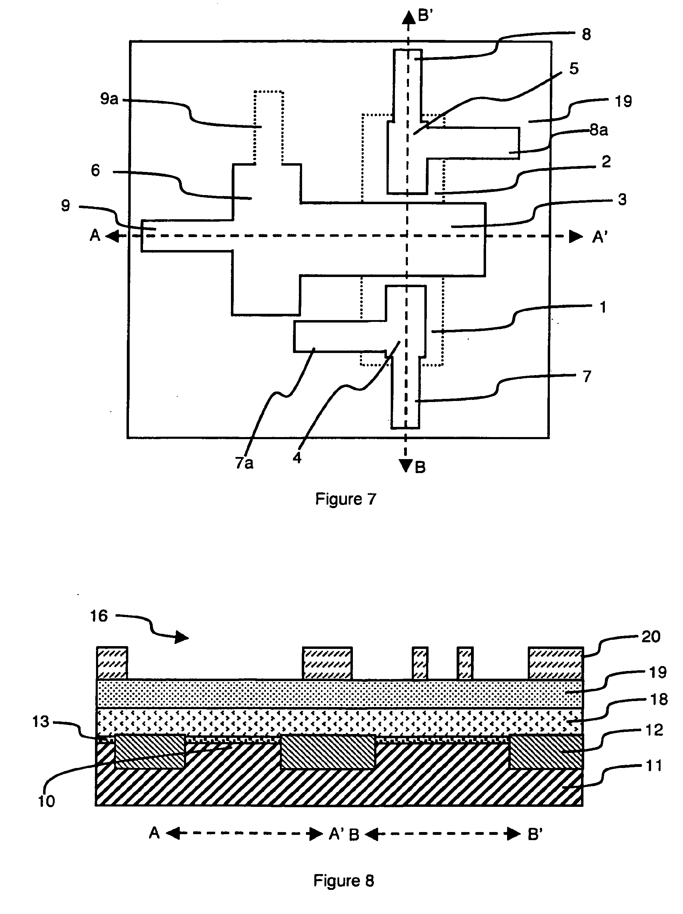

Comme illustré aux figures 7 et 8, le masque de gravure 16 comporte le dessin de l'électrode de grille 3 qui sert à délimiter les électrodes de source 1 et de drain 2 dans la zone active 10. Le masque de gravure 16 comporte également le dessin des zones délimitant les futurs contacts de source 4 et de drain 5 qui seront formés sur les électrodes de source 1 et de drain 2. Le masque de gravure 16 comporte encore le dessin des lignes de sortie de source 7, de drain 8, et de grille 9 du premier niveau d'interconnexion métallique également appelé premier niveau de métal. Ces lignes de sortie vont connecter les contacts de source 4, de drain 5 et de grille 6 de tous les transistors d'un circuit intégré. Ces lignes de sortie du premier niveau de métal sont généralement complétées par des niveaux d'interconnexions supplémentaires. Les lignes de sortie de source, de drain et de grille du premier niveau de métal connectent le transistor aux autres dispositifs du circuit intégré afin de former une fonction prédéfinie. Le premier niveau d'interconnexion métallique est constitué par une pluralité de motifs en matériau métallique qui sont entourés par un matériau électriquement isolant. Les lignes de sortie de source 7, de drain 8, et de grille 9 du premier niveau d'interconnexion métallique sont des motifs en matériau métallique qui forment des lignes ou des via. Un via est un plot essentiellement vertical visant à faire passer le courant à un niveau d'interconnexion supérieur.

Au moyen du dessin formé dans le masque de gravure, il est possible avec un seul niveau photolithographique de définir latéralement la position des électrodes de source 1, de drain 2 et des contacts de source 4, de drain 5 et de grille 6 et des lignes de sortie de source 7, de drain 8, et de grille 9 du premier niveau de métal, par rapport à l'électrode de grille 3.

Le dessin conventionnel de l'électrode de grille 3 est prolongé du coté du futur contact de grille 6 par le dessin de la ligne de sortie de grille 9 du premier niveau d'interconnexion métallique.

Le dessin des contacts de source 4 et de drain 5 est également prolongé respectivement par les dessins des lignes de sortie de source 7 et de drain 8 du premier niveau de métal. Les dessins des lignes de sortie de source 7 et de drain 8 du premier niveau de métal sont formés, par exemple, sur les bords les plus éloignés de l'électrode de grille (zones 7 et 8), mais ils pourraient être formés sur d'autres bords latéraux de la zone de contact dans la mesure où il y un espace suffisant (lignes de sortie 7a et 8a). Dans l'exemple particulier de la figure 7, en éliminant les lignes de sortie 7a et 8a, les dessins de la source et du drain (contact et premier niveau de métal) présentent un axe de symétrie qui est perpendiculaire à l'axe de symétrie de l'électrode de grille 3 (sans la ligne 9a).

Les formes de l'électrode de grille 3, des contacts de source 4, de drain 5 et des lignes de sortie de source 7, de drain 8, et de grille 9 du premier niveau de métal sont représentées dans le masque de gravure 16 par des zones vides délimitées par la couche supérieure d'isolation 20. La couche supérieure d'isolation 20 sert de masque dur pour les étapes de gravure ultérieures. Le masque de gravure est donc choisi dans un matériau suffisamment résistant pour servir de masque dur et il présente une épaisseur suffisante pour pouvoir intégrer, par la suite, le premier niveau de métal. Les dessins de l'électrode de grille et de la ligne de sortie de grille ne forment qu'une seule zone vide dans le masque 16. De même, les dessins du contact de source 4 et de la ligne de sortie de source 7 et les dessins du contact de source 5 et de la ligne de sortie de source 8 forment chacun une seule zone vide.

Une fois le masque de gravure 16 formé, les lignes de sortie de source 7, de drain 8 et de grille 9 sont masquées par toute technique adaptée afin de ne graver que les zones délimitant latéralement l'électrode de grille et les contacts de source et de drain dans la couche d'isolation. Ce masque peut être réalisé simplement par une étape additionnelle de photolithographie préalable à la gravure.

Il est également possible d'utiliser un premier matériau d'obturation 21 avec le masque de gravure. Le premier matériau d'obturation 21 forme des premiers bouchons dans le masque de gravure ou au-dessus du masque de gravure afin de ne graver, par la suite, que l'électrode de grille et les contacts de source et de drain dans la couche d'isolation. Dans une variante de réalisation non représentée, une fois le premier matériau d'obturation 21 déposée, l'étape de photolithographie additionnelle laisse libre le dessin de l'électrode de grille 3 et des contacts de source 4 et de drain 5 pour venir éliminer le premier matériau d'obturation 21 dans ces zones. Dans une autre variante (non représentée), il est également possible d'utiliser une étape de photolithographie présentant un dessin de polarité inverse à ce qui a été décrit plus haut et dans ce cas le premier matériau d'obturation sera structuré par une technique dite « à décollement ». Dans ces modes de réalisation, il n'y a pas de contraintes dimensionnelles sur les lignes de sortie du premier niveau de métal.

Dans un mode de réalisation privilégié, les lignes de sortie de source 7, de drain 8, et de grille 9 du premier niveau de métal présentent une dimension longitudinale et/ou transversale qui est inférieure à la plus petite des dimensions longitudinales et transversales de l'électrode de grille 3 et des zones de contact de source 4 et de drain 5.

Sur la figure 7, le dessin de l'électrode de grille 3 et de la ligne de sortie de grille 9 du premier niveau de métal présente un axe de symétrie AA' qui permet de définir selon cet axe au moins trois portions dans le dessin de la grille. Le dessin de la grille comporte une portion étroite, ici rectangulaire, qui définit la ligne de sortie de grille 9 du premier niveau de métal. Cette portion étroite est suivie d'une portion large, à l'intérieur de laquelle sera formé le contact de grille 6. La portion large est elle-même suivie d'une portion intermédiaire qui délimite l'électrode de grille au-dessus de la zone active et donc la longueur physique du canal. La portion intermédiaire recouvre donc la zone active 10 afin de définir les électrodes de source 1 et de drain 2. Les électrodes de source 1 et de drain 2 sont disposées de part et d'autre de l'électrode de grille 3 et donc de l'axe de symétrie AA'.

De manière générale, la portion étroite est séparée de la portion intermédiaire par la portion large. Il n'est pas nécessaire que le dessin de la grille présente un axe de symétrie. Il est parfaitement envisageable de décaler la portion large de la portion intermédiaire afin de former, par exemple, un L. La portion étroite peut également être décalée par rapport à la portion large. Il n'est pas nécessaire que les trois portions soient alignées, la portion étroite peut être orientée selon une autre direction comme cela est représenté, à titre d'exemple, par la ligne de sortie de grille additionnelle 9a. Il est également envisageable de former plusieurs lignes de sortie de grille 9 du premier niveau de métal pour une seule zone de contact de grille 6.

De manière générale, la portion large présente des dimensions transversales et longitudinales supérieures à la plus petite des dimensions transversales et longitudinales de la portion intermédiaire, ici, selon l'axe BB' qui relie la source et le drain. Typiquement, les dimensions de la portion large de la grille sont au moins 10nm plus grandes que la dimension de la grille qui définit la longueur du canal, c'est-à-dire la distance entre l'électrode de source et l'électrode de drain. De manière générale, l'axe AA' représente la direction longitudinale de la grille et les électrodes de source et de drain sont disposées de part et d'autre de cet axe AA'.

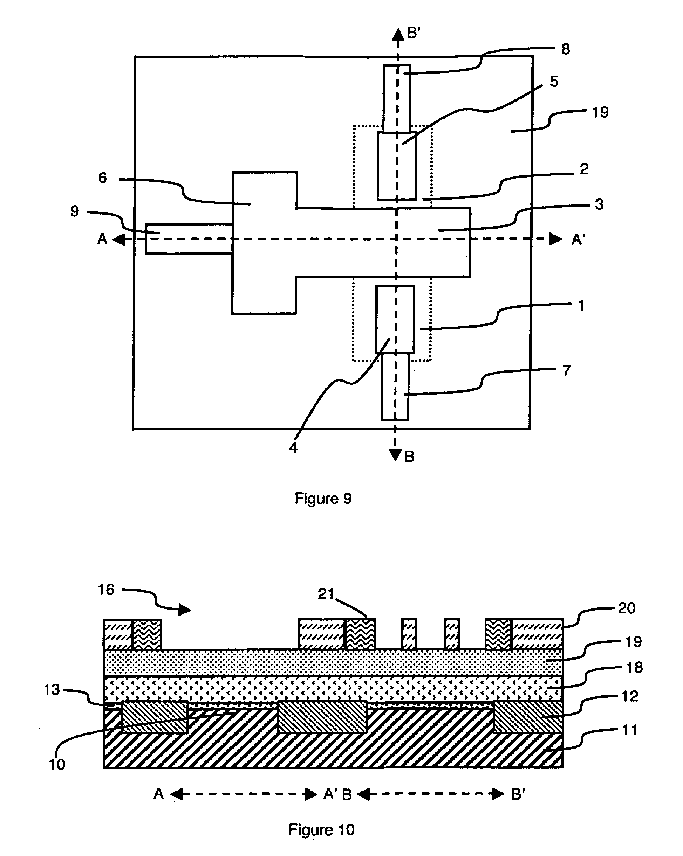

Au moyen de ces contraintes dimensionnelles, il est possible de boucher les lignes de sortie de source 7, de drain 8, et de grille 9 du premier niveau de métal sans utiliser de niveau photolithographique supplémentaire. Comme illustré aux figures 9 et 10, le premier matériau d'obturation 21 est déposé de manière conforme, c'est-à-dire de façon homogène sur les surfaces horizontales et verticales du masque de gravure 16, sur la couche supérieure d'isolation 20 et sur la couche d'isolation 19. L'épaisseur du premier matériau d'obturation 21 est choisie de manière à boucher les lignes de sortie de source 7, de drain 8 et de grille 9 du premier niveau de métal dans le masque de gravure 16. Le premier matériau d'obturation 21 est alors gravé de manière isotrope afin de venir éliminer le matériau 21 déposé sur le masque de gravure et le matériau déposé dans les zones délimitant les contacts de source 4 et de drain 5 et dans le dessin de l'électrode de grille 3. Le premier matériau d'obturation est, par exemple, en polysilicium ou en alliage de silicium-germanium polycristallin ou amorphe. De manière générale, le premier matériau d'obturation 21 est dans un matériau qui permet une gravure sélective des couches 18 et 19 tout en autorisant l'arrêt de la gravure sur les couches 12 et 13. Le premier matériau d'obturation 21 doit pouvoir également être éliminé sélectivement par rapport aux autres matériaux en présence. Sur l'exemple de la figure 9, les premiers bouchons en matériau 21 délimitent les lignes de sortie de source 7, de drain 8 et de grille 9 dans le masque de gravure. On observe alors en vue de dessus des motifs distincts.

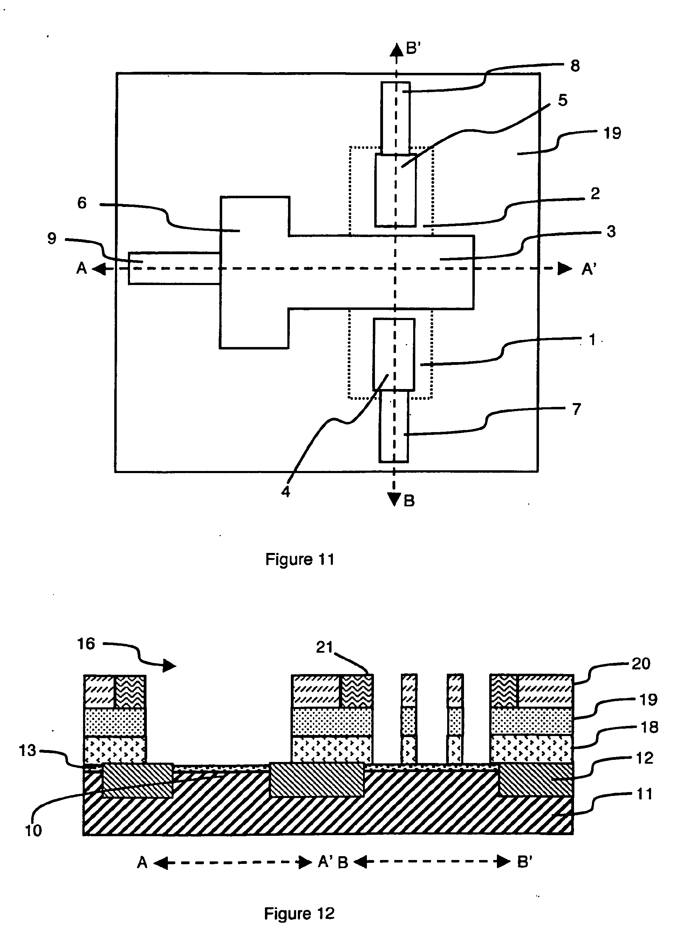

Comme illustré aux figures 11 et 12, une gravure anisotrope est réalisée afin de structurer la couche d'isolation au niveau des première 18 et seconde 19 couches élémentaires en matériau d'isolation. La forme de l'électrode de grille 3 est définie, simultanément aux zones délimitant les contacts de source 4 et de drain 5 par des zones vides formées dans les première 18 et deuxième 19 couches élémentaires en matériau d'isolation comme illustré à la figure 12 en coupe. La forme de l'électrode de grille 3 est ainsi définie dans la couche d'isolation et la gravure s'arrête sur le diélectrique de grille 13 et sur le matériau diélectrique 12.

Une fois l'électrode de grille 3 et les contacts de source 4 et de drain 5 délimités latéralement dans la couche d'isolation, le masquage des futurs contacts de source 4 et de drain 5 est réalisé avant de former l'électrode de grille 3.

Le masquage peut être réalisé de différentes manières. A titre d'exemple, le masquage peut provenir d'une étape de photolithographie additionnelle qui ne laisse libre que la zone délimitant l'électrode de grille 3. Dans ce cas de figure, le matériau de grille 23 est déposé par dépôt directionnel, par exemple, par évaporation et sa structuration est réalisée par une technique dite « à décollement ». Il est également possible d'utiliser un second matériau d'obturation 22 qui va former des seconds bouchons au-dessus ou dans les futurs contacts de source 4 et de drain 5. Comme précédemment pour la formation des premiers bouchons, le second matériau d'obturation 22 peut être structuré au moyen d'au moins une étape de photolithographie additionnelle pour former des seconds bouchons (non représenté).

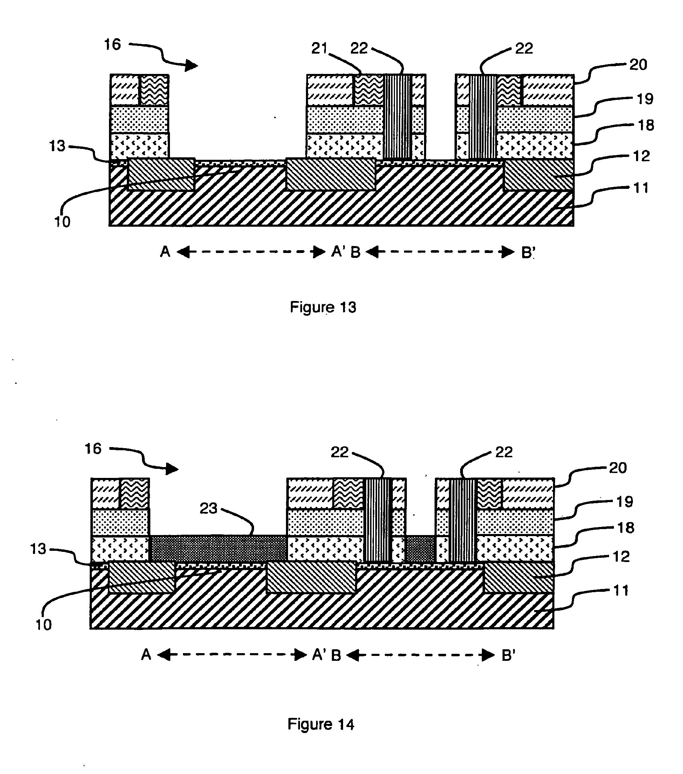

Dans un mode de réalisation privilégié, comme illustré à la figure 13, les seconds bouchons en second matériau d'obturation 22 sont alors formés au moins dans le masque de gravure 16 pour reboucher les zones de contact de source 4 et de drain 5 laissées libres. Comme illustré à la figure 14, avantageusement, les seconds bouchons en second matériau d'obturation 22 remplissent l'ancien volume vide des première 18 et deuxième 19 couches élémentaires en matériau d'isolation et du masque de gravure 16 qui correspond aux zones des futurs contact de source 4 et dé drain 5. Les seconds bouchons sont formés par le second matériau d'obturation 22 qui est également déposé de manière conforme. Une épaisseur prédéfinie du second matériau d'obturation 22 est déposée ce qui a pour effet de boucher les zones délimitant les contacts de source 4 et de drain 5. Le second matériau d'obturation 22, déposé sur le masque de gravure et dans la zone délimitant latéralement l'électrode de grille, est éliminé au moyen d'une gravure isotrope. Le second matériau d'obturation 22 est, par exemple, en tétraéthylorthosilicate (TEOS).

Si les premiers bouchons en premier matériau d'obturation 21 ont été éliminés avant le dépôt du second matériau d'obturation 22, les premiers bouchons sont alors reformés par le second matériau d'obturation. Selon les modes de réalisation, il peut être nécessaire d'avoir des premiers et seconds bouchons formés dans des matériaux différents.

A cette étape, les premiers bouchons qui obstruaient les lignes de sortie de source 7, de drain 8 et de grille 9 du premier niveau de métal sont conservés.

Comme illustré à la figure 14, un matériau de grille 23 est formé dans le volume vide qui délimite l'électrode de grille 3. Le matériau de grille forme l'électrode de grille 3. La localisation du matériau de grille 23 dans le volume vide délimitant l'électrode de grille est réalisée en déposant le matériau de grille jusqu'à venir remplir complètement tout le volume délimitant l'électrode de grille 3. Le matériau de grille 23 se déposant également sur le masque de gravure 16, une étape de polissage mécano-chimique est réalisée afin d'éliminer le matériau de grille hors du volume de l'électrode de grille 3.

Avantageusement, une gravure isotrope, par exemple par gravure chimique par plasma, est ensuite réalisée afin d'éliminer la partie supérieure du matériau de grille 23 et ainsi localiser ce matériau exclusivement dans la partie inférieure du volume délimitant l'électrode de grille 3. Le matériau de grille 23 présente alors une épaisseur sensiblement égale à celle de la première couche en matériau d'isolation 18.

Dans un mode de réalisation particulier, la grille métallique, le contact et le premier niveau de métal associé sont formés en une seule étape et dans le même matériau. Il n'y a alors plus de distinction nette entre l'électrode, son contact et le premier niveau de métal. Avantageusement, le matériau utilisé serait le cuivre. Si nécessaire, il peut y avoir une différence dans les matériaux utilisés et/ou dans l'ordre de formation des dispositifs afin de pourvoir différencier les dispositifs PMOS des NMOS. Dans ce mode de réalisation particulier, les premiers bouchons sont éliminés avant la formation du matériau de grille 23. Dans ce mode de réalisation, les premiers bouchons sont éliminés avant le dépôt du matériau 23.

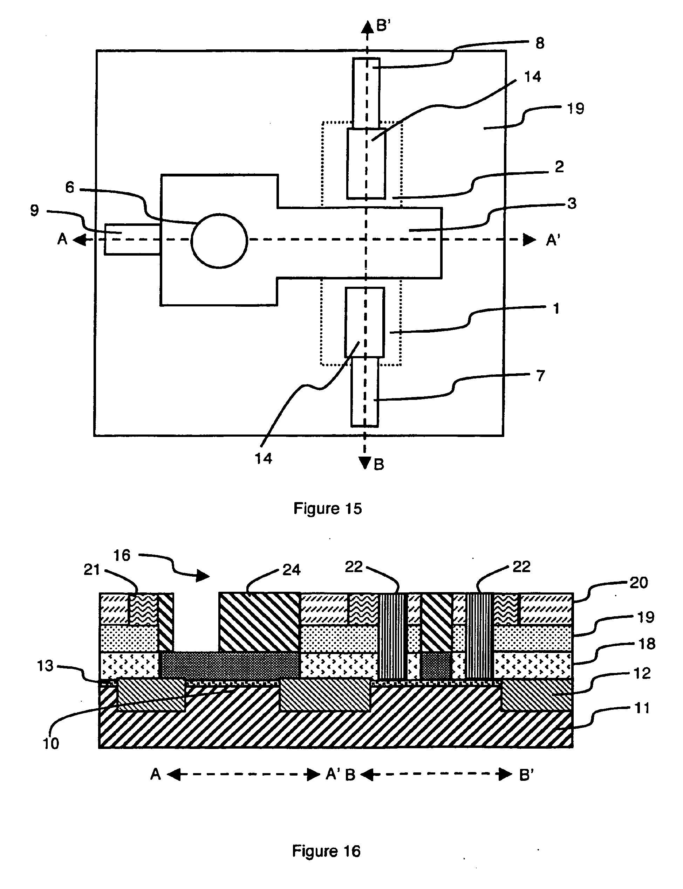

Comme illustré aux figures 15 et 16, si le matériau de grille 23 ne remplit pas tout le volume de la grille, un matériau de recouvrement 24, est déposé de manière conforme sur le masque de gravure 16, la couche d'isolation et le matériau de grille 23. Le dépôt étant conforme, le matériau de recouvrement 24 couvre de manière uniforme toutes les surfaces visibles horizontales ou verticales du dispositif. L'épaisseur du matériau de recouvrement 24 et les conditions du procédé de gravure isotrope sont choisies de manière à remplir complètement le volume du masque de gravure 16 et, ici, de la deuxième couche en matériau d'isolation 19 qui correspond à la portion intermédiaire tout en laissant accessible une partie du matériau de grille 23 dans la portion large de la grille afin de former la zone délimitant le contact de grille 6. De ce fait, l'épaisseur de matériau 24 qui est déposée doit être suffisamment importante pour boucher la portion intermédiaire (l'électrode de grille 3 au dessus de la zone active) tout en étant suffisamment mince pour ne pas boucher complètement la portion large qui contient le futur contact de grille 6. Il doit subsister une dépression dans le matériau 24 au niveau de la portion large. Les zones de contact 7, 8 et 9 du premier niveau de métal sont obstruées par les premiers bouchons 21. Le matériau de recouvrement est avantageusement en matériau isolant, par exemple, en oxyde ou en nitrure de silicium ou un mélange de ces deux matériaux.

De manière non obligatoire, le matériau de recouvrement 24 est ensuite soumis. à une étape de polissage mécano-chimique afin d'éliminer le matériau de recouvrement 24 qui est situé au-dessus du masque de gravure 16. Le polissage mécano-chimique peut être réalisé si il reste du matériau de recouvrement 24 sur le masque de gravure après l'étape de gravure isotrope.

La surface libre du matériau de grille 23 qui est disposée dans la portion large correspond au contact de grille 6. La surface libre a ici une forme circulaire et elle est disposée au centre de la portion large, comme illustré à la figure 15 en vue de dessus. La forme du futur contact de grille 6 et sa position dépendent de la forme initiale de la portion large de la grille et de l'épaisseur de matériau de recouvrement qui a été déposée.

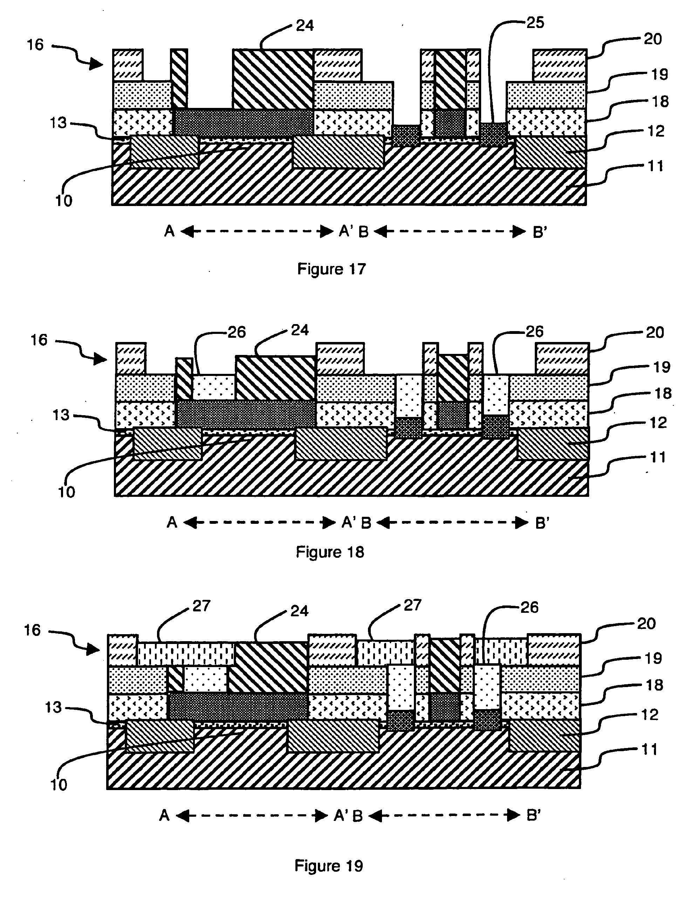

Comme illustré à la figure 17, les seconds bouchons sont éliminés sélectivement pas rapport aux autres matériaux présents. Le diélectrique de grille 13 laissé libre est à son tour éliminé pour permettre l'accès à la zone active 10. Les parties de la zone active 10 mises à nue formant l'interface avec les contacts de source 4 et de drain 5 peuvent faire l'objet, par exemple, d'une implantation de dopants et/ou d'une épitaxie sélective. La zone active 10, au niveau des contacts de source 4 et de drain 5, peut également être siliciurée afin d'améliorer la prise des contacts sur le dispositif. Un métal est déposé sur le dispositif et il subit un traitement thermique afin de la faire réagir avec le matériau de la zone active 10. Cette réaction forme un siliciure 25 dans les zones actives de source et de drain.

Durant cette étape technologique, les premiers bouchons peuvent être éliminés, par exemple, en même temps que les seconds bouchons ou après la formation du siliciure. A cette même étape technologique, le matériau de recouvrement 24 peut subir une gravure anisotrope ou isotrope. La gravure isotrope à pour effet d'agrandir la zone de contact de grille 6 et réduire l'épaisseur du matériau de recouvrement. La gravure anisotrope réalise l'amincissement du matériau de recouvrement sans vraiment modifier les dimensions du contact de grille.

Comme illustré à la figure 18, un matériau métallique 26 est ensuite déposé afin de former au moins les contacts de source 4, de drain 5 et de grille 6. Le matériau métallique 26 étant déposé sur l'ensemble du dispositif, il est soumis à une étape de polissage mécano-chimique afin de le localiser uniquement dans le masque de gravure 16 et/ou dans la couche d'isolation au niveau de la source, du drain et de la grille. Avantageusement, il est également soumis à une étape de gravure additionnelle afin de le localiser pour former uniquement les contacts de source, de drain et de grille.

Comme illustré à la figure 19, un second matériau métallique 27 formant le premier niveau de métal est alors déposé et structuré. La structuration est réalisée, par exemple, par un polissage mécano-chimique. Ainsi, les lignes de sortie de source 7, de drain 8 et de grille 9 du premier niveau de métal sont en connexion avec respectivement les zones de contact de source 4, de drain 5 et de grille 6. Si un matériau isolant empêche la connexion entre le contact de grille et la zone de grille du premier niveau de métal, ce matériau isolant est gravé. Dans l'exemple des figures 18 et 19, le matériau de recouvrement est soumis à une gravure avantageusement isotrope.

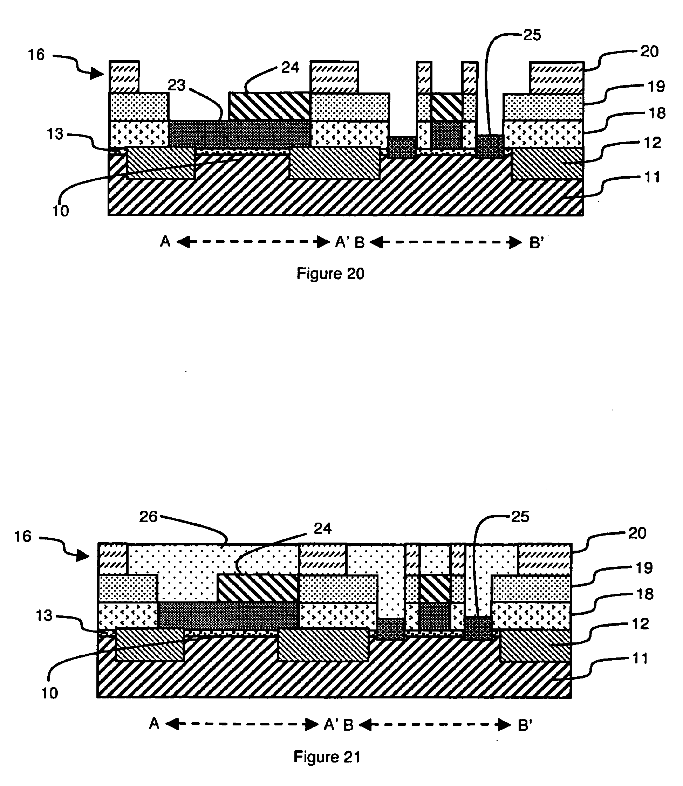

Comme illustré à la figure 20, dans une variante de réalisation après la figure 17, les premiers bouchons sont éliminés et le matériau de recouvrement 24 est partiellement éliminé afin d'être localisé préférentiellement dans la portion intermédiaire de la grille. Le matériau de recouvrement 24 peut être soumis à une gravure anisotrope, par exemple une gravure par plasma ou par voie humide. En variante, le matériau de recouvrement 24 peut être éliminé au moyen d'une étape supplémentaire de photolithographie qui ne rend accessible que la portion large de la grille suivie d'une étape de gravure. Dans un cas extrême (figure 20), le matériau de recouvrement 24 ne subsiste que dans la portion intermédiaire du dessin de la grille et le contact de grille 6 est formé par la portion large du dessin de grille.

Comme illustré à la figure 21, le matériau métallique 26 est déposé sur le dispositif de manière à boucher complètement les volumes vides au moins dans la couche d'isolation. Le matériau métallique 26 est ensuite soumis à une étape de polissage mécano-chimique afin d'éliminer le matériau 26 qui est situé au dessus du masque de gravure 16. Une étape de gravure est avantageusement réalisée afin d'amincir le matériau métallique. Ce matériau métallique 26 va former les plots de contact pour la source, le drain et la grille et il va former également le premier niveau d'interconnexion métallique du transistor.

Le reste du dispositif est réalisé de manière conventionnelle, notamment les niveaux métalliques suivant de l'empilement d'interconnexion.

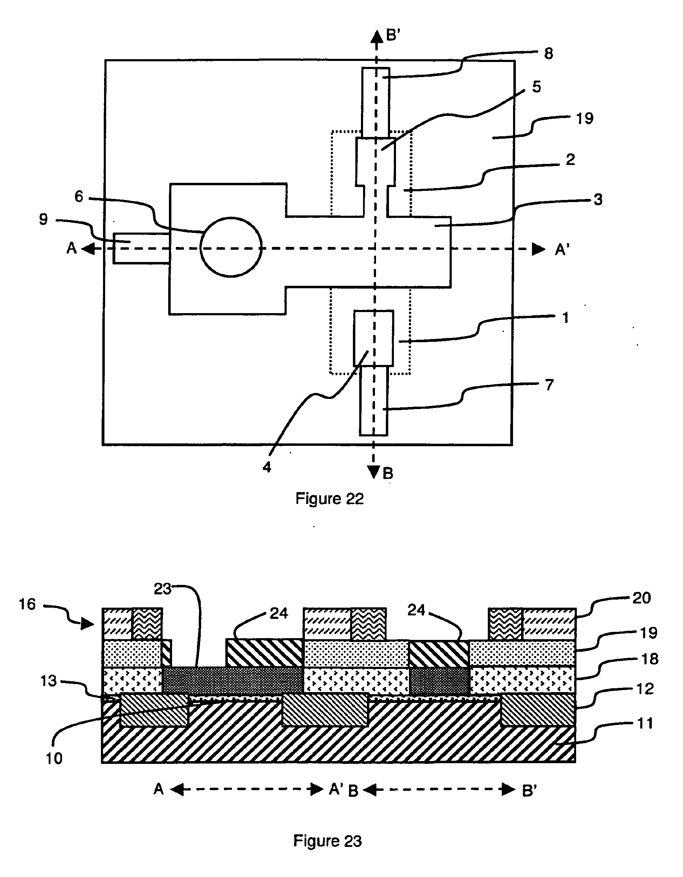

Dans une autre variante de réalisation illustrée à la figure 22, dans le masque de gravure 16, le dessin de la grille est prolongé par les dessins du contact de source 4 et/ou du contact de drain 5. Sur la figure 22 seule le contact de drain 5 est connecté à l'électrode de grille 3. Une zone de liaison sépare le dessin de l'électrode de grille de celui du contact de source et/ou de drain.

La zone de liaison est masquée lors de la délimitation de l'électrode de grille 3 et des contacts de source 4 et de drain 5 dans la couche d'isolation. Le masquage de la zone de liaison est réalisé en même temps que celui des lignes de sortie de source 7, de drain 8 et de grille 9 du premier niveau de métal et avec les mêmes techniques. Avantageusement, la connexion est réalisée par une zone de liaison qui présente selon l'axe AA' une dimension transversale inférieure aux dimensions longitudinales et transversales des contacts de source 4 et de drain 5 et de l'électrode de grille afin d'éviter d'utiliser une étape photolithographique additionnelle.

La formation de la grille et des contacts de source et de drain est réalisée comme précédemment. La zone de liaison est remplie par le matériau métallique du premier niveau d'interconnexion métallique en même temps que les lignes de sortie 7, 8 et 9.

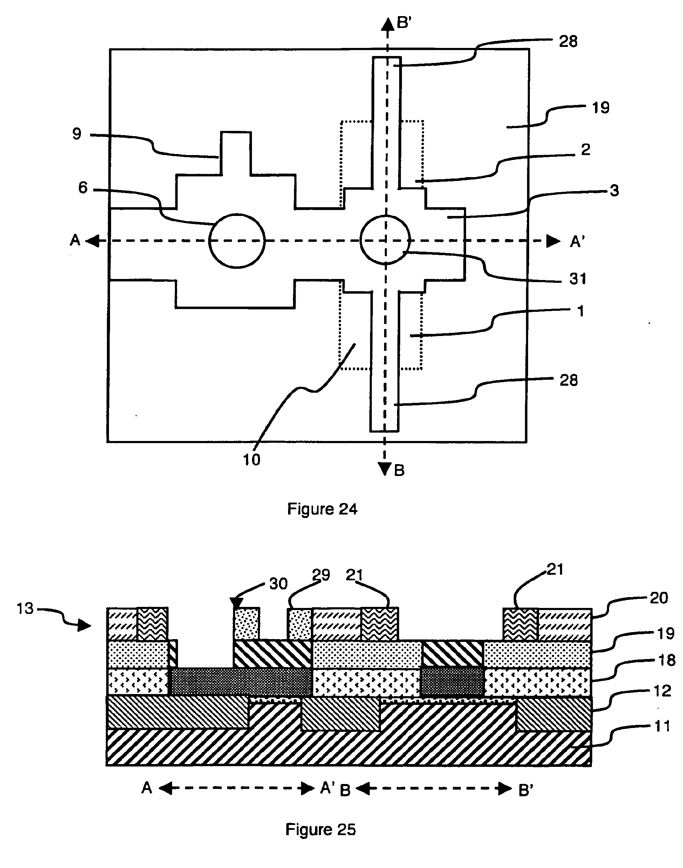

Dans un autre mode de réalisation, illustré aux figures 23 à 27, l'électrode de grille est traversée par une ligne de métal du premier niveau de métal sans que cette ligne ne soit en contact électrique avec le matériau de grille 23. Le dessin de l'électrode de grille, dans le masque de gravure 16, présente deux portions larges, la première portion large et une portion large additionnelle. La première portion large permet la définition du contact de grille 6 comme dans les modes de réalisation précédents. La portion large additionnelle présente des dimensions transversales ou longitudinales inférieures à la plus petite des dimensions transversales et longitudinales de la première portion large. La portion intermédiaire présente également des dimensions transversales ou longitudinales inférieures à la plus petite des dimensions transversales et longitudinales de la portion large additionnelle. Une portion de séparation est formée entre la première portion large et la portion large additionnelle. La dimension transversale de la portion de séparation est inférieure aux dimensions transversales et longitudinales des portions larges et au maximum égale à celle de la portion intermédiaire. Dans l'exemple de la figure 24, la dimension de la portion de séparation selon la direction BB' est inférieure aux dimensions selon les directions AA' et BB'.

Le masque de gravure 16 comporte une ligne de transit 28 du premier niveau de métal qui traverse la portion large additionnelle. Le dessin de l'électrode de grille 3 est donc prolongé par deux portions de la ligne de transit 28 au niveau de la portion large additionnelle.

Comme dans les modes de réalisation précédents, la ligne de transit 28 du premier niveau de métal est masquée lors de la délimitation de l'électrode de grille 3 et des contacts de source 4 et de drain 5. Ce masquage peut être réalisé par toute technique adaptée, avantageusement en imposant des contraintes dimensionnelles à la ligne de transit afin d'éviter l'utilisation d'une étape additionnelle de photolithographie. Les contraintes dimensionnelles de la lignes de transit 28 sont identiques à celles des lignes de sortie 7, 8 et 9 du premier niveau de métal. De cette manière, des premiers bouchons 21 sont formés en même temps que dans les zones de source 7, de drain 8 et de grille 9 du premier niveau de métal et dans la ligne de transit 28.

Le procédé de réalisation est identique à celui décrit précédemment jusqu'à la figure 16. A ce moment, la zone délimitant le contact de grille 6 est formée dans le matériau de recouvrement et la gravure du matériau de recouvrement 24 est poursuivie afin de réduire l'épaisseur du matériau de recouvrement 24 (figure 23). Des premiers bouchons 21 sont présents.

Comme illustré aux figures 24 et 25, un matériau de recouvrement additionnel 29 est déposé de manière conforme sur le dispositif et est ensuite gravé de manière isotrope. Comme pour le matériau de recouvrement 24, les contraintes géométriques imposées aux diverses portions du dessin présent dans le masque de gravure 16 font que la portion de séparartion disposée entre la première portion large et la portion large additionnelle est rebouchée avant les deux portions larges (figure 24). La gravure isotrope du matériau 29 est réalisée au moins une fois que la portion de séparation est bouchée. De cette manière, après l'étape de gravure, il se forme au moins un plot de séparation 30 en matériau 29 qui sépare les deux zones larges (figure 25). Durant la formation de ce plot 30; il y a également redélimitation du contact de grille 6 car le précédent trou n'est pas rebouché et il y a délimitation d'une zone de contact additionnelle 31 dans la portion large additionnelle. Cette zone de contact additionnelle 31 n'est pas reliée au matériau de grille 23. La zone de contact additionnelle est liée à la forme du plot de séparation 30. La forme de la zone de contact additionnelle est liée à la forme de la portion additionnelle et aux épaisseurs déposées puis gravées du matériau 29. Comme le contact de grille, le contact additionnel 31 est formé sans utiliser d'étape photolithographique et sa forme dépend également de la forme initiale de la portion large associée.

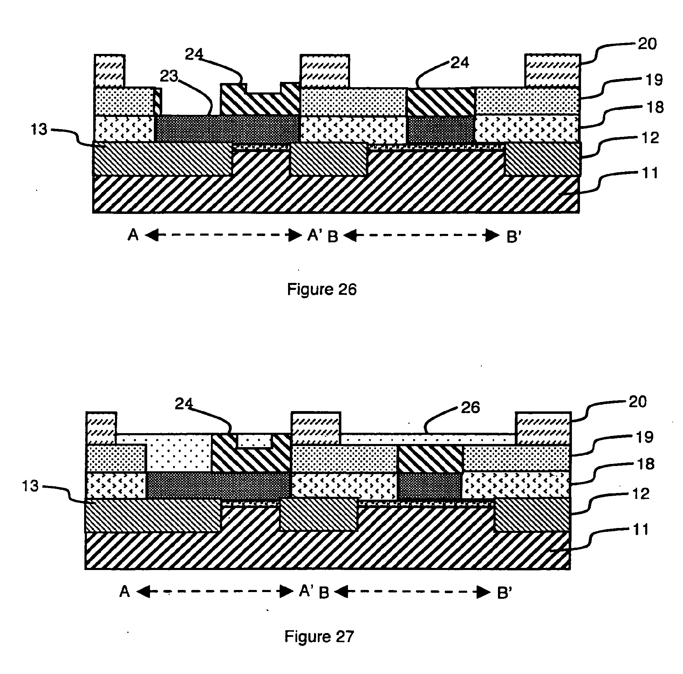

Comme illustré à la figure 26, le matériau de recouvrement 24 et le matériau de recouvrement additionnel 29 sont soumis à une étape de gravure avantageusement isotrope afin de réduire leur épaisseur. De cette manière, la topographie de surface présente sur les couches de recouvrement 24 et 29 est reproduite et seule l'épaisseur de ces couches est diminuée. Dans un cas extrême illustré à la figure 26, la couche de recouvrement additionnelle 29 est complètement éliminée. Durant cette étape de gravure, les lignes de sortie de source 7, de drain 8 et de grille 9 et la ligne de transit 28 du premier niveau de métal sont ouvertes, c'est-à-dire que les premiers bouchons 21 sont éliminés.

Comme illustré à la figure 27, le matériau métallique 26 est déposé sur le dispositif afin de remplir les espaces vides et former ainsi les contacts de source 4, de drain 5 et de grille 6. Le matériau métallique forme simultanément les lignes de sortie de source 7, de drain 8 et de grille 9 et la ligne de transit 28 du premier niveau de métal. Le matériau métallique 26 est soumis à un polissage mécano-chimique afin de le localiser dans et sous le masque de gravure 16 et une étape de gravure isotrope ou anisotrope est réalisée afin de réduire l'épaisseur du matériau métallique 26 et ainsi éviter un court-circuit entre le contact de grille et le contact additionnel 30.

De manière générale, le dispositif à effet de champ présente des contacts de source 4, de drain 5 qui sont autoalignés par rapport à l'électrode de grille 3. Ceci est obtenu au moyen d'un procédé qui comporte au moins l'utilisation d'un masque de gravure qui délimite simultanément au moins les zones de contact de source 4, de drain 5 et l'électrode de grille 3 dans le matériau d'isolation 18, 19, 20. Le dispositif présente également des lignes de sortie de source 7, de drain 8 et de grille 9 qui sont autoalignées par rapport aux contact de source 4, de drain 5 et de grille 6, donc par rapport à l'électrode de grille 3. Le plot 30 qui est reproduit ici dans la couche 24 évite les court-circuits entre la ligne de transit 28 et la grille. De cette manière, il est possible de s'affranchir des contraintes technologiques liées aux équipements de photolithographie.

Dans certains des modes de réalisation décrits, le contact de grille peut également être autoaligné par rapport à l'électrode de grille, il est également envisageable d'utiliser toute la partie large de la grille en tant que zone de contact 6. Cependant, il est également possible de former un contact de grille au moyen d'une étape supplémentaire de photolithographie bien que ce mode de réalisation ne soit pas très favorable.

Tous les modes de réalisation décrits permettent la réalisation d'un transistor à effet de champ dans lequel les zones de contact de source 4 et de drain 5 sont autoalignés par rapport à l'électrode de grille 3 ce qui permet de manière simple et répétable d'obtenir des dispositifs de petites dimensions.

Selon les modes de réalisation et les épaisseurs des matériaux utilisés, la position relative et la distinction entre les contacts et les lignes de sorties associées varient. En effet, dans certains modes de réalisation la ligne de sortie peut être au-dessus du contact ou alors être autour du contact ou être confondue avec le contact.

## Revendications

1. Procédé de réalisation d'un dispositif à effet de champ comportant, dans un premier niveau d'interconnexion métallique, des lignes de sorties de source (7), de drain (8) et de grille (9) connectées respectivement à des contacts de source (4), de drain (5) et de grille (6), lesdits contacts étant disposés respectivement sur des électrodes de source (1), de drain (2) et de grille (3), procédé **caractérisé en ce qu'**il comporte successivement:
- la formation d'une couche d'isolation (18, 19, 20) sur un diélectrique de grille (13),
- la réalisation d'un masque de gravure (16) délimitant latéralement au moins l'électrode de grille (3), les contacts de source (4) et de drain (5) et les lignes de sortie de source (7), de drain (8) et de grille (9) du premier niveau de métal,
- le masquage des lignes de sortie de source (7), de drain (8) et de grille (9) du premier niveau de métal dans le masque de gravure (16),
- la délimitation simultanée de l'électrode de grille (3) et des zones de contact de source (4) et de drain (5) dans la couche d'isolation (18, 19, 20),
- le dépôt d'un matériau de grille (23) formant au moins l'électrode de grille (3),
- la formation des contacts de source (4) et de drain (5) au moins dans la couche d'isolation, et des lignes de sortie de source (7), de drain (8) et de grille (9) du premier niveau de métal dans le masque de gravure (16).

2. Procédé selon la revendication 1, **caractérisé en ce que** le dessin de la grille comportant une portion large et une portion intermédiaire, les dimensions transversales et longitudinales des lignes de sortie de source (7), de drain (8) et de grille (9) du premier niveau de métal sont inférieures à la plus petite des dimensions transversales et longitudinales desdites portions large et intermédiaire.

3. Procédé selon l'une des revendications 1 et 2, **caractérisé en ce que** le masquage est réalisé uniquement dans les zones de source (7), de drain (8) et de grille (9) du premier niveau d'interconnexion métallique.

4. Procédé selon les revendications 2 et 3, **caractérisé en ce qu'**un premier matériau d'obturation (21) est déposé de manière conforme et gravé de façon isotrope.

5. Procédé selon l'une des revendications 3 et 4, **caractérisé en ce que** le premier matériau d'obturation (21) est en silicium ou en alliage de silicium-germanium polycristallin ou amorphe.

6. Procédé selon l'une quelconque des revendications 3 à 5, **caractérisé en ce qu'**il comporte l'élimination du premier matériau d'obturation (21) entre la formation de l'électrode de grille (3) et la formation des contacts de source (4), de drain (5) et de grille (6), et des lignes de sortie de source (7), de drain (8) et de grille (9) du premier niveau d'interconnexion métallique.

7. Procédé selon l'une quelconque des revendications 1 à 6, **caractérisé en ce qu'**il comporte, avant la formation de l'électrode de grille (3), la formation de seconds bouchons dans les contacts de source (4) et de drain (5), au moins dans le masque de gravure (16).

8. Procédé selon la revendication 7, **caractérisé en ce qu'**il comporte l'élimination du premier matériau d'obturation (21) avant la formation des contacts de source (4) et de drain (5).

9. Procédé selon l'une quelconque des revendications 2 à 8, **caractérisé en ce que** le contact de grille (6) est délimité par un matériau de recouvrement (24) déposé de manière conforme et gravé de façon anisotrope, le contact de grille (6) étant disposée dans la portion large.

## Claims

1. Method for producing a field effect device comprising source (7), drain (8) and gate (9) output lines respectively connected to source (4), drain (5) and gate (6) contacts in a first metallic interconnection level, said contacts being respectively arranged on source (1), drain (2) and gate (3) electrodes, a method **characterized in that** it successively comprises:
- formation of an insulating layer (18, 19, 20) on a gate dielectric (13),
- making an etching mask (16) laterally delineating at least the gate electrode (3), source (4) and drain (5) contacts and source (7), drain (8) and gate (9) output lines of the first metal level,
- masking the source (7), drain (8) and gate (9) output lines of the first metal level in the etching mask (16),
- simultaneous delineation of the gate electrode (3) and of the source (4) and drain (5) contact areas in the insulating layer (18, 19, 20),
- deposition of a gate material (23) forming at least the gate electrode (3),
- formation of the source (4) and drain (5) contacts at least in the insulating layer, and of the source (7), drain (8) and gate (9) output lines of the first metal level in the etching mask (16).

2. Method according to claim 1, **characterized in that** the gate pattern comprising a wide portion and an intermediate portion, the transverse and longitudinal dimensions of the source (7), drain (8) and gate (9) output lines of the first metal level are smaller than the smallest transverse and longitudinal dimensions of said wide and intermediate portions.

3. Method according to one of claims 1 and 2, **characterized in that** masking is performed only in the source (7), drain (8) and gate (9) areas of the first metallic interconnection level.

4. Method according to claims 2 and 3, **characterized in that** a first sealing material (21) is deposited in conformal manner and etched in isotropic manner.

5. Method according to one of claims 3 and 4, **characterized in that** the first sealing material (21) is made from polycrystalline or amorphous silicon or silicon-germanium alloy.

6. Method according to any one of claims 3 to 5, **characterized in that** it comprises elimination of the first sealing material (21) between formation of the gate electrode (3) and formation of the source (4), drain (5) and gate (6) contacts, and of the source (7), drain (8) and gate (9) output lines of the first metallic interconnection level.

7. Method according to any one of claims 1 to 6, **characterized in that**, before formation of the gate electrode (3), it comprises formation of second plugs in the source (4) and drain (5) contacts, at least in the etching mask (16).

8. Method according to claim 7, **characterized in that** it comprises elimination of the first sealing material (21) before formation of the source (4) and drain (5) contacts.

9. Method according to any one of claims 2 to 8, **characterized in that** the gate contact (6) is delineated by a covering material (24) deposited in conformal manner and etched in anisotropic manner, the gate contact (6) being located in the wide portion.

## Patentansprüche

1. Verfahren zur Herstellung einer Feldeffekt-Vorrichtung, die in einer ersten Metallverbindungsebene eine Source- (7), eine Drain- (8) und eine Gate-Ausgangsleitung (9) umfasst, die an einen Source- (4), einen Drain- (5) bzw. einen Gate-Kontakt (6) angeschlossen sind, wobei die Kontakte auf einer Source- (1), einer Drain- (2) bzw. einer Gate-Elektrode (3) angeordnet sind, Verfahren, welches **dadurch gekennzeichnet ist, dass** es nacheinander umfasst:
- das Ausbilden einer Isolierschicht (18, 19, 20) auf einem Gate-Dielektrikum (13),
- das Herstellen einer Ätzmaske (16), die wenigstens die Gate-Elektrode (3), den Source- (4) und den Drain-Kontakt (5) sowie die Source- (7), die Drain- (8) und die Gate-Ausgangsleitung (9) der ersten Metallebene seitlich begrenzt,
- die Maskierung der Source- (7), der Drain- (8) und der Gate-Ausgangsleitung (9) der ersten Metallebene in der Ätzmaske (16),
- das gleichzeitige Begrenzen der Gate-Elektrode (3) sowie des Source- (4) und des Drain-Kontaktbereiches (5) in der Isolierschicht (18, 19, 20),
- das Abscheiden eines Gate-Materials (23), das wenigstens die Gate-Elektrode (3) bildet,
- das Ausbilden des Source- (4) und des Drain-Kontaktes (5) wenigstens in der Isolierschicht sowie der Source- (7), der Drain- (8) und der Gate-Ausgangsleitung (9) der ersten Metallebene in der Ätzmaske (16).

2. Verfahren nach Anspruch 1, **dadurch gekennzeichnet, dass** ― da das Muster des Gate einen breiten Abschnitt und einen Zwischenabschnitt umfasst ― die Quer- und Längsabmessungen der Source- (7), der Drain- (8) und der Gate-Ausgangsleitung (9) der ersten Metallebene kleiner sind als die kleinste der Quer- und Längsabmessungen des breiten Abschnitts und des Zwischenabschnitts.

3. Verfahren nach einem der Ansprüche 1 und 2, **dadurch gekennzeichnet, dass** die Maskierung lediglich in den Source- (7), Drain- (8) und Gate-Bereichen (9) der ersten Metallverbindungsebene vollzogen wird.

4. Verfahren nach den Ansprüchen 2 und 3, **dadurch gekennzeichnet, dass** ein erstes Verschlussmaterial (21) konform abgeschieden und isotrop geätzt wird.

5. Verfahren nach einem der Ansprüche 3 und 4, **dadurch gekennzeichnet, dass** das erste Verschlussmaterial (21) aus Silizium oder aus polykristalliner oder amorpher Silizium/Germanium-Legierung besteht.

6. Verfahren nach einem der Ansprüche 3 bis 5, **dadurch gekennzeichnet, dass** es das Entfernen des ersten Verschlussmaterials (21) zwischen dem Ausbilden der Gate-Elektrode (3) und dem Ausbilden der Source- (4), Drain- (5) und Gate-Kontakte (6) sowie der Source- (7), Drain- (8) und Gate-Ausgangsleitungen (9) der ersten Metallverbindungsebene umfasst.

7. Verfahren nach einem der Ansprüche 1 bis 6, **dadurch gekennzeichnet, dass** es vor dem Ausbilden der Gate-Elektrode (3) das Ausbilden von zweiten Pfropfen in dem Source- (4) und dem Drain-Kontakt (5), wenigstens in der Ätzmaske (16) umfasst.

8. Verfahren nach Anspruch 7, **dadurch gekennzeichnet, dass** es das Entfernen des ersten Verschlussmaterials (21) vor dem Ausbilden des Source- (4) und des Drain-Kontaktes (5) umfasst.

9. Verfahren nach einem der Ansprüche 2 bis 8, **dadurch gekennzeichnet, dass** der Gate-Kontakt (6) durch ein Abdeckmaterial (24), das konform abgeschieden und anisotrop geätzt ist, begrenzt ist, wobei der Gate-Kontakt (6) in dem breiten Abschnitt angeordnet ist.
